# FASCICULE DE BREVET EUROPEEN

(11) **EP 4 083 489 B1**
(45) Date de publication et mention de la délivrance du brevet: **23.10.2024**
(21) Numéro de dépôt: 22169740.2
(22) Date de dépôt: 25.04.2022
(51) Int. Cl.: F16L 55/07, F16L 21/03

(54) **CONNECTEUR**
ANSCHLUSS
CONNECTOR

(30) Priorité: 30.04.2021 FR 2104571
(43) Date de publication de la demande: 02.11.2022
(73) Titulaire: A. Raymond et Cie, 38000 Grenoble (FR)
(72) Inventeur: GWON, Hongseok, 18476 Hwaseong-si, Gyeonggi-do (KR); CHOI, Jinsub, 18476 Suwon-si, Gyeonggi-do (KR)
(74) Mandataire: Ipside

(56) Documents cités:
- JP-A- 2000 320 426
- KR-B1- 101 891 318
- US-A1- 2005 046 180
- US-A1- 2016 116 095

## Description

### Domaine technique de l'invention

La présente invention concerne un connecteur, notamment une structure pour connecter un tuyau s'étendant depuis une plaque de refroidissement à l'intérieur d'un boîtier à un tuyau se trouvant à l'extérieur du boîtier. Plus particulièrement, la présente invention se rapporte à un connecteur rapide entre une plaque de refroidissement au sein d'une unité de contrôle du moteur et un réservoir de réserve externe comportant de fluide caloporteur.

### Technique antérieure

Il est important de gérer l'aspect thermique dans les véhicules électriques et hybrides. L'unité de contrôle du moteur d'un véhicule hybride se trouve dans un boîtier dans lequel une plaque de refroidissement est utilisé pour refroidir cette unité de contrôle. À cet effet, un liquide caloporteur, tel que de l'eau, circule via un tuyau entre la plaque de refroidissement et une source externe. Il est nécessaire de garantir les performances de fuite de la connexion entre le tuyau et l'unité de contrôle du moteur assurée par un connecteur, afin d'éviter l'apparition du liquide caloporteur dans le boîtier. On connaît de l'état de la technique ce type de connecteur.

Le document brevet US 2015/0152987 A1 décrit une structure de connexion comportant un tuyau de joint qui relie un tuyau interne et un tuyau externe, le tuyau interne étant lié à une plaque de refroidissement et un tuyau externe. Le dispositif présente une structure complexe ayant plusieurs flans. En plus, un éventuel endommagement du joint torique se trouvant entre le tuyau de joint et le tuyau interne rendrait la connexion défectueuse. En outre, une connexion rapide n'est pas engageable avec ce dispositif. Un autre problème, il est nécessaire de prévoir des tolérances d'assemblage car le tuyaux interne et le tuyau externe sont séparés par un écart. Document brevet JP 2000 320426 A décrit un tube de carburant à haute pression pour un moteur diesel, qui est fourni en tant que voie d'alimentation en carburant près du moteur. Document brevet US 2005/046180 A1 décrit des joints d'étanchéité qui sont adaptées à l'accouplement étanche de pièces fabriquées dans des matériaux différents. Document brevet KR 101 891 318 B1 décrit un joint tournant comprenant un corps de support de joint relié à une bride pour la rotation d'un arbre tout en supportant la rotation de l'arbre. Document brevet US 2016/116095 A1 décrit un raccord de ligne avec deux voies d'écoulement mutuellement séparées pour la connexion d'une ligne tuyau dans tuyau.

### Exposé de l'invention

La présente invention propose un connecteur qui permet de connecter à tubes, particulièrement aux tubes de plaque de refroidissement.

Un premier aspect de l'invention se rapporte à un connecteur pour connecter à tubes, comportant un corps comprenant une première partie tubulaire, une bride sur la circonférence extérieure et à une extrémité de la première partie tubulaire, le connecteur comprend au moins deux joints circulaires ou tubulaires distancés et agencés sur une surface périphérique intérieure de la première partie tubulaire, dans lequel, - le connecteur comporte un canal de fuite qui connecte une ouverture de fuite et la bride, l'ouverture de fuite étant disposée entre les joints.

L'invention est avantageusement mise en oeuvre selon les modes de réalisation et les variantes exposées ci-après, lesquelles sont à considérer individuellement ou selon toute combinaison techniquement opérante.

Dans un mode de réalisation, le connecteur comporte un espaceur entre les joints.

Dans un mode de réalisation, les joints sont des joints toriques.

Dans un mode de réalisation, le connecteur comporte un élément de blocage axial servant à fixer un tube dans le sens axial auquel il est connecté, un diamètre intérieur de la première partie tubulaire étant plus grand qu'un diamètre extérieur du tube.

Dans un mode de réalisation, l'élément de blocage axial se trouve entre une extrémité opposée à la bride de la première partie tubulaire et un des joints le plus proche de cette extrémité.

Dans un mode de réalisation, le connecteur comporte une deuxième partie tubulaire disposée à l'autre surface de bride opposée à la partie tubulaire, les deux parties tubulaires formant un passage de fluide, préférentiellement, les deux parties tubulaires étant coaxiaux.

Dans un mode de réalisation, le connecteur comporte en outre deux joints circulaires ou tubulaires, de préférence deux joints toriques, distancés et agencés sur une surface périphérique intérieure de la deuxième partie tubulaire.

Un deuxième aspect de l'invention se rapporte à une utilisation d'un connecteur selon la présente invention dans une unité de contrôle du moteur, caractérisée en ce que la première partie tubulaire et le canal de fuite se trouve à l'intérieur de l'unité de contrôle du moteur.

Un troisième aspect de l'invention se rapporte à un système de refroidissement. Ce système comporte une plaque de refroidissement et un réservoir de liquide de refroidissement, ces derniers étant connecté par un connecteur.

Un quatrième aspect de l'invention se rapporte à un onduleur de véhicule électrique, ce dernier comportant un connecteur selon la présente invention.

Avantageusement, le connecteur selon la présente invention une structure simple, tout en gardant une performance de fuite élevée même en cas de défaillance d'un joint. En outre, il est possible de réaliser une connexion rapide avec le connecteur de la présente invention. De plus, le connecteur comporte une bride avec lequel le connecteur peut être fixé à la paroi interne d'un boîtier, ceci permettant d'éliminer les tolérances d'assemblage et maintenir une performance étanche à l'air dans des conditions de température sévères.

### Brève description des figures

la Figure 1 représente une vue d'une unité de contrôle du moteur comportant des connecteurs selon la présente invention, d'où les connecteurs sont liés aux plaques de refroidissement ;
la Figure 2 représente une vue en coupe partielle selon A-A de l'unité de contrôle du moteur illustrée sur la Fig. 1 ;
la Figure 3 représente une autre vue en coupe partielle selon A-A de l'unité de contrôle du moteur illustrée sur la Fig. 1, d'où un joint est défectueux ;
la Figure 3A représente un autre mode de réalisation du connecteur selon la présente l'invention ;
la Figure 4A représente un mode de réalisation du connecteur selon la présente invention comportant un deuxième partie tubulaire femelle et apte à connecter à un réservoir de liquide caloporteur ;
la Figure 4B représente un mode de réalisation du connecteur selon la présente invention comportant un tuyau comme un deuxième partie tubulaire;
la Figure 4C représente un mode de réalisation du connecteur selon la présente invention comportant un deuxième partie tubulaire mâle ;
la Figure 5 représente une plaque de refroidissement pourvue des tuyaux qui sont prêts à raccorder avec des connecteurs selon la présente invention.

### Description des modes de réalisation

Les différentes figures ainsi que les éléments d'une même figure ne sont pas nécessairement représentées à la même échelle. Sur l'ensemble des figures, les éléments identiques portent la même référence numérique.

La terminologie employée dans la présente description ne doit en aucun cas être interprétée de manière limitative ou restrictive, simplement parce qu'elle est employée en conjonction avec une description détaillée de certains modes de réalisation de l'invention.

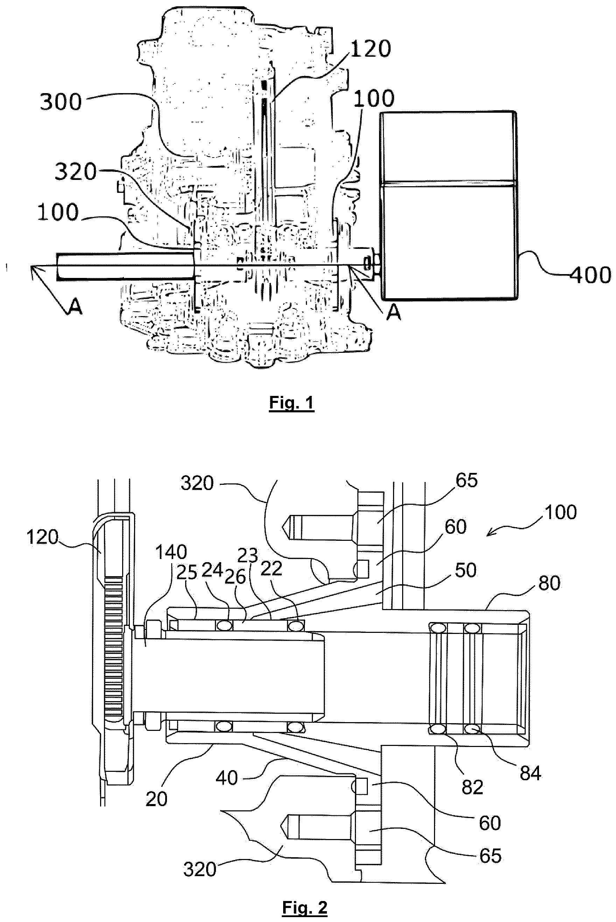

La Figure 1 représente une vue d'une unité de contrôle du moteur 10 comportant des connecteurs 100 selon la présente invention, d'où les connecteurs 100 sont liés aux plaques de refroidissement. Les plaques de refroidissement se trouvent, avec l'unité de contrôle du moteur, au sein d'un boîtier r. L'unité de contrôle du moteur se refroidisse au moyen des plaques de refroidissement. Un liquide de refroidissement ou un liquide caloporteur, tel que de l'eau, circule entre les plaques 200 de refroidissement et un réservoir 400. Les plaques de refroidissement sont pourvues de tubes 140 servant entrée et sortie du liquide de refroidissement. Les tubes 140 peuvent connecter à une première partie tubulaire 20 du connecteur 100. Le connecteur 100 comporte une bride 60 sur la circonférence extérieure et à une extrémité de la première partie tubulaire 20. Ainsi, le connecteur peut être fixé à la paroi du boîtier 300, par exemple au moyen des boulons. La bride présente deux trous débouchants opposés à travers desquels les boulons 320 fixent la bride 60 à la paroi du boîtier 300. Il est essentiel que les performances de fuite entre les tubes 140 et le connecteur 20 soient assurées afin d'éviter la présence de liquide dans le boîtier. À l'autre côté de la bride 60, le connecteur 100 présente une ouverture donnant à l'extérieur du boîtier 300.

La Figure 2 représente une vue en coupe partielle selon A-A de l'unité de contrôle du moteur illustrée sur la Fig. 1. En effet, il s'agit d'une vue en coupe suivant le plan comportant l'axe de la première partie tubulaire 20 et l'axe liant les deux trous débouchants présents sur la bride 60. Le connecteur 100 comprend deux joints circulaires ou tubulaires 22, 24 distancés et agencés sur une surface périphérique intérieure de la première partie tubulaire 20. Les joints 22, 24 permet de garantir une étanchéité lorsque le tube 140 est inséré dans la première partie tubulaire 20. Avantageusement, le connecteur 100 comporte un canal de fuite 50 formé entre une ouverture de fuite 23 et la bride 60, l'ouverture de fuite 23 étant disposée entre les joints 22, 24. Lorsque le premier joint 22 est défaillant, le liquide de refroidissement fuit de s'écoule par l'ouverture de 23 et puis le canal de fuite 50 jusqu'à une ouverture du canal présente sur la bride 60, ainsi la fuite s'écoule entièrement hors du boîtier 300. Cet agencement permet avantageusement d'assurer une performance de fuite satisfaisante même lors de la défaillante du premier joint 22.

Dans un mode de réalisation préféré, le connecteur 100 comporte un espaceur 26 entre les joints 22, 24. Cet espaceur 26 permet de garder une distance axiale entre les joints 22, 24. L'emplacement de l'espaceur 26 correspond à l'ouverture de fuite 23 se trouvant entre les joints 22, 24, or l'espaceur 26 n'a pas pour effet de boucher l'ouverture de fuite 23. Cet espaceur 26 peut être de forme tubulaire. Donc une éventuelle fuite peut s'écouler toujours par le canal de fuite 50 malgré la présence de cet espaceur 26.

Avantageusement, le connecteur 100 présente deux canaux de fuite 50 opposés.

Dans un mode de réalisation, la bride 60 comporte deux trous débouchants via lesquels le connecteur 100 peut être fixé à la paroi du boîtier 300 comportant des orifices à cet effet au moyen des boulons 65. Des moyens d'étanchéité sont avantageusement prévus entre la bride 60 et la paroi interne du boîtier. Ceci permet d'éliminer les tolérances d'assemblage et maintenir une performance étanche à l'air dans des conditions de température sévères.

Dans un mode de réalisation, le connecteur comporte un élément 25 de blocage axial qui peut fixer un tube 140 dans le sens axial auquel il est connecté, un diamètre intérieur de la première partie tubulaire 20 étant plus grand qu'un diamètre extérieur du tube 140. L'élément 25 de blocage assure la connexion entre le connecteur 100 et le tube dans le sens axial.

Le tube forme une entrée ou une sortie de liquide caloporteur pour la plaque de refroidissement 120. Le tube 140 peut être inséré dans la première partie tubulaire 20.

Dans un mode de réalisation, le connecteur 100 comporte avantageusement une deuxième partie tubulaire 80 disposée à l'autre surface de bride opposée à la partie tubulaire 80, les deux parties tubulaires 20, 80 formant un passage de fluide. Préférentiellement, les deux parties tubulaires 20, 80 sont coaxiaux. Ceci sera détaillé plus loin.

Dans un mode de réalisation, le connecteur 100A comporte en outre deux joints circulaires ou tubulaires 82, 84, de préférence deux joints toriques, distancés et agencés sur une surface périphérique intérieure de la deuxième partie tubulaire 80A.

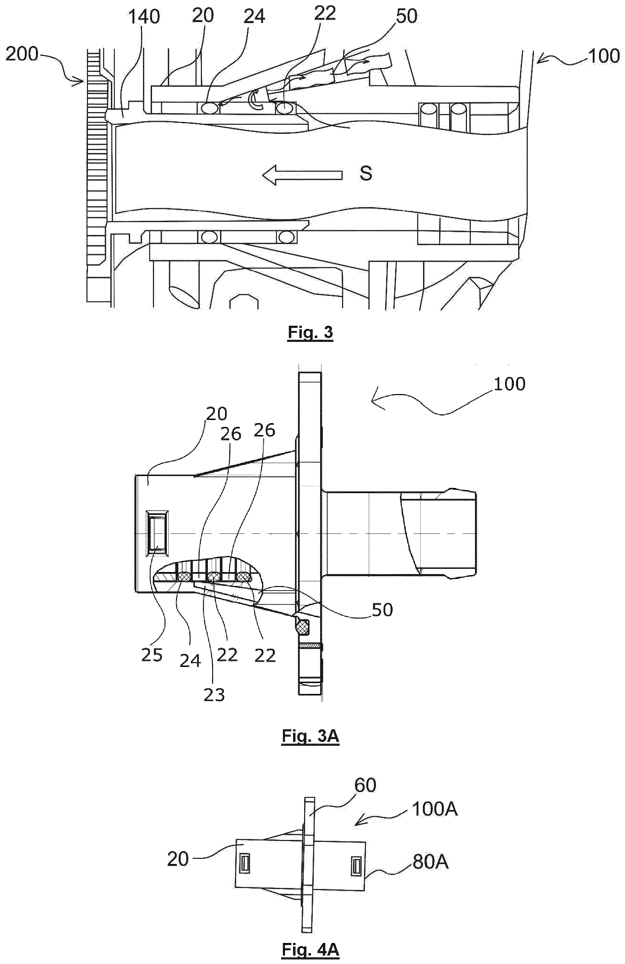

La Figure 3 représente une autre vue en coupe partielle selon A-A de l'unité de contrôle du moteur illustrée sur la Fig. 1 selon un autre mode de réalisation, d'où un premier joint 22 est défectueux. Dans ce mode de réalisation, le liquide de refroidissement circule dans le sens indiqué S vers la plaque de refroidissement, en passant par la première partie tubulaire 20 et le tube 140. Le premier joint 22 étant défectueux, le liquide de refroidissement peut entrer dans l'espace formé entre par la première partie tubulaire 20 et le tube 140. Grâce à l'ouverture 23 présente sur la première partie tubulaire 20, le liquide en fuite s'écoule par le canal 50. L'ouverture de fuite 23 se trouvant avantageusement entre les deux joints 22, 24, le deuxième joint assure donc les fonctions d'étanchéité entre la première partie tubulaire 20 et le tube 140. Le liquide en fuite s'écoule en dehors du boîtier 300 via des ouvertures prévues à la bride et la paroi du boîtier 300. Le liquide de refroidissement peut atteindre une température élevée dans le passage de fluide. À cette température, le liquide de refroidissement sous forme vapeur peut franchir premier joint 22 et apparaître entre les deux joints 22, 24, même si le premier joint 22 ne soit pas complètement défectueux. Avantageusement, le liquide de refroidissement sous forme de vapeur sort ensuite par le canal 50. Donc, cet arrangement permet également de diminuer la pression exercée sur le deuxième joint 24 lors de la défaillance du premier joint 22 ou lors de la présence du liquide de refroidissement sous forme de vapeur de haute température entre les deux joints 22, 24.

Dans un mode de réalisation, le connecteur 100 comporte entre les joints 22, 24 un espaceur 26 qui permet de séparer les joints 22, 24, notamment à côtés différents de l'ouverture de fuite 23. Comme l'espaceur 26 n'a pas pour effet de boucher l'ouverture de fuite 23, le liquide en fuite peut s'écouler toujours par le canal de fuite 50.

Dans un mode de réalisation illustré sur la Figure 3A, le connecteur 100 comprend une première partie tubulaire 20 qui comprend en outre un autre premier joint 22. Ainsi, l'ouverture de fuite 23 est disposée entre les deux premiers joints 22 et le deuxième joint 24. Avantageusement, le premier joint 22 supplémentaire renforce la performance d'étanchéité du connecteur 100. De préférence, le connecteur 100 peut comporter un espaceurs 26 tel qu'illustré plus haut et en outre entre les premiers joints 22 un autre espaceur 26 qui séparent les deux premiers joints 22. Les autres caractéristiques peuvent être les mêmes que pour le mode de réalisation représenté sur la Figure 2.

La Figure 4A représente un mode de réalisation du connecteur selon la présente invention comportant un deuxième partie tubulaire femelle et apte à connecter à un réservoir 400 de liquide caloporteur. Le connecteur 100A comporte un troisième et un quatrième joints circulaires ou tubulaires 82, 84. Les joints 82, 84 sont distancés et agencés sur une surface périphérique intérieure de la deuxième partie tubulaire 80A. Ce connecteur 100A est apte à connecter au réservoir 400 de liquide de refroidissement qui est pourvu d'un tube femelle à cet effet.

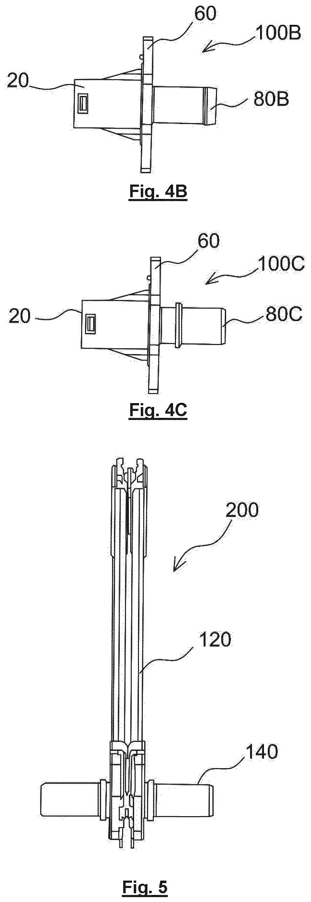

La Figure 4B représente un mode de réalisation du connecteur 100B selon la présente invention comportant un tuyau comme un deuxième partie tubulaire 80B. Le connecteur 100B ayant cette configuration est apte à connecter à un tube souple.

La Figure 4C représente un mode de réalisation du connecteur 100C selon la présente invention comportant un deuxième partie tubulaire mâle 80C. Le connecteur 100C selon ce mode de réalisation est apte à connecter à un tube femelle.

Avantageusement, le connecteur selon la présente invention présente une adaptabilité élevée pour connecter à des tubes de différents types afin de former le passage de liquide de refroidissement.

La Figure 5 illustre une plaque de refroidissement 120 pourvue des tubes 140 qui sont prêts à raccorder avec des connecteurs 100, 100A, 100B, 100C selon la présente invention. Une connexion rapide est engageable entre le connecteur 100, 100A, 100B, 100C et un tube de la plaque de refroidissement.

La présente invention se rapporte également à une unité de contrôle du moteur comportant au moins un connecteur 100 ; 100A ; 100B ; 100C. La première partie tubulaire 20 et le canal de fuite 50 se trouvent à l'intérieur de l'unité de contrôle du moteur. La première partie tubulaire 20 est connectée à une plaque de refroidissement qui se situe également au sein de l'unité de contrôle du moteur.

Dans un mode de réalisation, la présente invention se rapporte à un système de refroidissement, qui comporte une plaque de refroidissement 120 et un réservoir 400 de liquide de refroidissement, ces derniers étant connecté par un connecteur 100 ; 100A ; 100B ; 100C.

La présente invention se rapporte également à onduleur de véhicule électrique, qui comporte un connecteur 100 ; 100A ; 100B ; 100C selon la présente invention.

De manière générale, les joints sont de préférence des joints toriques.

### LISTE DES SIGNES DE RÉFÉRENCE

**[Tableaux 1]**

| Références | Désignations |
|---|---|
| 10 | Unité de contrôle moteur hybride avec des connecteurs de plaque de refroidissement |
| 100 ;100A ;100B ;100C | Connecteur plaque de refroidissement |
| 20 | Première parie tubulaire, corps |
| 22 | Premier joint torique |
| 23 | Ouverture de fuite |
| 24 | Deuxième joint torique |
| 25 | Elément de blocage axial |
| 26 | Espaceur |
| 40 | Déflecteur |
| 50 | Canal/Ouverture de fuite/Orifice |
| 60 | Bride |
| 65 | Boulon |
| 80 ;80A ;80B ;80C | Deuxième partie tubulaire |
| 82 | Troisième joint torique |
| 84 | Quatrième joint torique |
| 200 | Ensemble de plaque de refroidissement |
| 120 | Plaque de refroidissement |
| 140 | Tube raccord de plaque de refroidissement (transfert de chaleur) |
| 300 | Unité de contrôle moteur |
| 220 | Couvercle |

## Revendications

1. Connecteur (100 ; 100A ; 100B ; 100C) pour connecter à tubes, particulièrement aux tubes de plaque de refroidissement, comportant un corps (20) comprenant une première partie tubulaire (20), une bride (60) sur la circonférence extérieure et à une extrémité de la première partie tubulaire (20), le connecteur (100 ; 100A ; 100B ; 100C) comprend au moins deux joints circulaires ou tubulaires (22, 24) distancés et agencés sur une surface périphérique intérieure de la première partie tubulaire (20),
**caractérisé en ce que**
le connecteur comporte un canal de fuite (50) qui connecte une ouverture de fuite (23) et la bride (60), l'ouverture de fuite (23) étant disposée entre les joints (22, 24), de préférence, l'ouverture de fuite (23) est disposée entre deux premiers joint (22) et un deuxième joint (24).

2. Connecteur (100 ; 100A ; 100B ; 100C) selon la revendication 1, dans lequel le connecteur comporte un espaceur (26) entre les joints (22, 24), l'emplacement de l'espaceur (26) correspondant à l'ouverture de fuite (23).

3. Connecteur (100 ; 100A ; 100B ; 100C) selon l'une des revendications précédentes, dans lequel le connecteur comporte un élément (25) de blocage axial servant à fixer un tube dans le sens axial auquel il est connecté, un diamètre intérieur de la première partie tubulaire (20) étant plus grand qu'un diamètre extérieur du tube.

4. Connecteur (100 ; 100A ; 100B ; 100C) selon la revendication 3, dans lequel l'élément (25) de blocage axial se trouve entre une extrémité opposée à la bride de la première partie tubulaire (20) et un des joints (22, 24) le plus proche de cette extrémité.

5. Connecteur (100 ; 100A ; 100B ; 100C) selon l'une des revendications précédentes, comportant une deuxième partie tubulaire (80) disposée à l'autre surface de bride opposée à la partie tubulaire (80), les deux parties tubulaires (20, 80) formant un passage de fluide, préférentiellement, les deux parties tubulaires (20, 80) étant coaxiaux.

6. Connecteur (100 ; 100A) selon la revendication 5, comportant en outre deux joints circulaires ou tubulaires (82, 84), de préférence deux joints toriques, distancés et agencés sur une surface périphérique intérieure de la deuxième partie tubulaire (80).

7. Connecteur (100 ; 100A) selon l'une des revendications précédentes, comportant deux canaux de fuite (50) opposés.

8. Système de refroidissement, comportant une plaque de refroidissement connecté à un connecteur (100 ; 100A ; 100B ; 100C) selon l'une des revendications 1 à 7.

## Patentansprüche

1. Verbindungsstück (100; 100A; 100B; 100C) zum Verbinden mit Rohren, insbesondere mit Kühlplattenrohren, das einen Körper (20) enthält, der einen ersten rohrförmigen Abschnitt (20) und einen Flansch (60) am Außenumfang und an einem Ende des ersten rohrförmigen Abschnitts (20) umfasst, wobei das Verbindungsstück (100; 100A; 100B; 100C) mindestens zwei kreisförmige oder rohrförmige Dichtungen (22, 24) umfasst, die voneinander beabstandet und an einer Innenumfangsfläche des ersten rohrförmigen Abschnitts (20) angeordnet sind,
**dadurch gekennzeichnet, dass**
das Verbindungsstück einen Leckagekanal (50) enthält, der eine Leckageöffnung (23) und den Flansch (60) verbindet, wobei die Leckageöffnung (23) zwischen den Dichtungen (22, 24) angeordnet ist, wobei vorzugsweise die Leckageöffnung (23) zwischen zwei ersten Dichtungen (22) und einer zweiten Dichtung (24) angeordnet ist.

2. Verbindungsstück (100; 100A; 100B; 100C) nach Anspruch 1, wobei das Verbindungsstück einen Abstandshalter (26) zwischen den Dichtungen (22, 24) umfasst, wobei die Position des Abstandshalters (26) der Leckageöffnung (23) entspricht.

3. Verbindungsstück (100; 100A; 100B; 100C) nach einem der vorhergehenden Ansprüche, wobei das Verbindungsstück ein axiales Blockierelement (25) enthält, das dazu dient, ein Rohr in der axialen Richtung, mit der es verbunden ist, zu befestigen, wobei ein Innendurchmesser des ersten rohrförmigen Abschnitts (20) größer ist als ein Außendurchmesser des Rohrs.

4. Verbindungsstück (100; 100A; 100B; 100C) nach Anspruch 3, wobei sich das axiale Blockierelement (25) zwischen einem Ende, das dem Flansch des ersten rohrförmigen Abschnitts (20) gegenüberliegt, und einer der Dichtungen (22, 24), die dem Ende am nächsten ist, befindet.

5. Verbindungsstück (100; 100A; 100B; 100C) nach einem der vorhergehenden Ansprüche, das einen zweiten rohrförmigen Abschnitt (80) enthält, der an der anderen Flanschoberfläche gegenüber dem rohrförmigen Abschnitt (80) angeordnet ist, wobei die beiden rohrförmigen Abschnitte (20, 80) einen Fluiddurchgang bilden, wobei die beiden rohrförmigen Abschnitte (20, 80) vorzugsweise koaxial sind.

6. Verbindungsstück (100; 100A) nach Anspruch 5, das ferner zwei kreisförmige oder rohrförmige Dichtungen (82, 84), vorzugsweise zwei O-Ringe, enthält, die voneinander beabstandet und auf einer Innenumfangsfläche des zweiten rohrförmigen Abschnitts (80) angeordnet sind.

7. Verbindungsstück (100; 100A) nach einem der vorhergehenden Ansprüche, das zwei gegenüberliegende Leckagekanäle (50) enthält.

8. Kühlsystem, das eine Kühlplatte enthält, die mit einem Verbindungsstück (100; 100A; 100B; 100C) nach einem der Ansprüche 1 bis 7 verbunden ist.

## Claims

1. A connector (100; 100A; 100B; 100C) for connecting to tubes, in particular to the cooling plate tubes, including a body (20) comprising a first tubular portion (20), a flange (60) on the outer circumference and at one end of the first tubular portion (20), the connector (100; 100A; 100B; 100C) comprises at least two circular or tubular seals (22, 24) which are spaced apart and arranged on an inner peripheral surface of the first tubular portion (20), **characterised in that**
the connector includes a leakage channel (50) which connects a leakage opening (23) and the flange (60), the leakage opening (23) being disposed between the seals (22, 24), preferably the leakage opening (23) is disposed between two first seals (22) and a second seal (24).

2. The connector (100; 100A; 100B; 100C) according to claim 1, wherein the connector includes a spacer (26) between the seals (22, 24), the location of the spacer (26) corresponding to the leakage opening (23).

3. The connector (100; 100A; 100B; 100C) according to one of the preceding claims, wherein the connector includes an axial blocking element (25) used to fasten a tube in the axial direction to which it is connected, an inner diameter of the first tubular portion (20) being larger than an outer diameter of the tube.

4. The connector (100; 100A; 100B; 100C) according to claim 3, wherein the axial blocking element (25) is located between an end which is opposite to the flange of the first tubular portion (20) and one of the joints (22, 24) closest to this end.

5. The connector (100; 100A; 100B; 100C) according to one of the preceding claims, including a second tubular portion (80) disposed at the other flange surface opposite to the tubular portion (80), the two tubular portions (20, 80) forming a fluid passage, preferably, the two tubular portions (20, 80) being coaxial.

6. The connector (100; 100A) according to claim 5, further including two circular or tubular seals (82, 84), preferably two O-rings, spaced apart and arranged on an inner peripheral surface of the second tubular portion (80).

7. The connector (100; 100A) according to one of the preceding claims, including two opposite leakage channels (50).

8. A cooling system, including a cooling plate connected to a connector (100; 100A; 100B; 100C) according to one of claims 1 to 7.
